# EUROPÄISCHE PATENTSCHRIFT

(11) **EP 2 612 155 B1**
(45) Veröffentlichungstag und Bekanntmachung des Hinweises auf die Patenterteilung: **28.02.2018**
(21) Anmeldenummer: 11767369.9
(22) Anmeldetag: 25.08.2011
(51) Int. Cl.: G01R 31/08

(54) **VORRICHTUNG UND VERFAHREN ZUR ORTUNG EINES ERDSCHLUSSES AN EINEM KABEL**
DEVICE AND METHOD FOR LOCATING AN EARTH FAULT ON A CABLE
DISPOSITIF ET PROCÉDÉ DE LOCALISATION D'UN DÉFAUT À LA TERRE DANS UN CÂBLE

(30) Priorität: 30.08.2010 DE 102010035882
(43) Veröffentlichungstag der Anmeldung: 10.07.2013
(73) Patentinhaber: MS-Technik Mess- und Regelungstechnik GmbH & Co. KG, 24232 Schönkirchen (DE)
(72) Erfinder: SCHACHT, Sebastian, 20144 Hamburg (DE)
(74) Vertreter: Hausfeld, Norbert
(86) Internationale Anmeldenummer: PCT/EP2011/004257
(87) Internationale Veröffentlichungsnummer: WO 2012/031692

(56) Entgegenhaltungen:
- US-A- 3 991 363
- US-A- 5 210 497
- US-A1- 2008 157 780
- US-B1- 6 798 211

## Beschreibung

Die Erfindung betrifft eine Vorrichtung nach dem Oberbegriff des Anspruches 1 und ein Verfahren nach dem Oberbegriff des Anspruches 4.

An Kabeln in Stromversorgungsnetzen treten häufig Fehler auf, die beseitigt werden müssen. Zuvor muss jedoch die Fehlerstelle gesucht werden.

Dazu sind Vorortungsverfahren bekannt, die zumeist mit Impulsreflexion arbeiten. Sie werden von einem Ende des Kabels her angewandt und können mit bestimmter Genauigkeit die Entfernung der Fehlerstelle auf dem Kabel ermitteln. Um zur Behebung des Fehlers die tatsächliche Lage der Fehlerstelle zu finden, muss jedoch auch die exakte Verlegegeometrie des Kabels bekannt sein, was insbesondere bei unterirdischer Verlegung selten mit ausreichender Zuverlässigkeit der Fall ist.

Daher werden zusätzlich Nachortungsverfahren angewendet. Bei unterirdisch verlegten Kabeln tritt häufig ein Erdschluss auf, also die Verbindung einer spannungsführenden Leitung des Kabels durch den defekten Kabelmantel hindurch nach außen zur Erde. Solche Fehler können sehr gut mit der sogenannten Schrittspannungsmessung gefunden werden, die z.B. in dem Aufsatz
"Methoden der Fehlerortung in Niederspannungsnetzen",
   Dr. Borneburg, Walter, Cichowski und Dr. Merschel,
"Jahrbuch Anlagentechnik für elektrische Verteilungsnetze 2008"
   VDE Verlag GmbH, Dezember 2007, Seiten 338 ff. Kapitel 2.2.1
beschrieben ist. Ausgehend von der Vorortung wird im Ortsbereich des vermuteten Fehlers mit einem Schrittspannungsmessgerät die exakte Fehlerposition nachbestimmt.

Bei diesem bekannten Verfahren wird die mit einem Fehler behaftete und zu untersuchende Leitung mit einer Gleichspannung beaufschlagt. Durch das Kabel fließt also ein Gleichstrom, der an der Stelle des Erdschlusses in das umgebende Erdreich austritt und in diesem nach allen Seiten abfliesst. Dabei wird das Erdreich an der Erdschlussstelle mit der Beaufschlagungsspannung beaufschlagt und diese Spannung fällt von dort aus mit wachsender Entfernung ab. Wird nun an der Erdoberfläche über dem Kabel mit der Auswerteinrichtung eine Schrittspannung gemessen, also die Spannungsdifferenz zwischen den zwei das Erdreich kontaktierenden Elektroden der Auswerteinrichtung, so ließe sich theoretisch aus dem Betrag der gemessenen Spannung auf den Abstand zum Erdschluss schließen. Dies würde aber exakte Kenntnis der Leitverhältnisse im Erdreich und der Tiefe der Leitung unterhalb der Erdoberfläche voraussetzen, so dass in der Regel nur relative Aussagen möglich sind, nämlich bezüglich zwei aufeinander folgender Messungen an unterschiedlichen Orten, ob man der Fehlerstelle näher gekommen ist oder sich weiter entfernt hat.

Da aber bei dem bekannten Verfahren das Kabel mit einer Gleichspannung beaufschlagt ist, deren Polarität bei der Auswertung der Schrittspannung bekannt und auswertbar ist, ergibt sich bei der Schrittspannungsmessung auch eine Information zur Richtung zum Erdschluss, also eine Angabe, welche der beiden Elektroden der Auswerteinrichtung näher zur Stelle des Erdschlusses liegt. In diese Richtung kann dann weitergesucht werden. Diese Information kann dem Vorzeichen der gemessenen Spannungsdifferenz entnommen werden, wenn das Vorzeichen der beaufschlagten Gleichspannung bekannt ist. Insgesamt ergibt sich ein sehr schneller und direkter Messvorgang zur Fehlerortung. Es entfällt das mühselige Herumsuchen mit mehreren Messungen, das bei früheren Methoden ohne Richtungserkennung erforderlich war.

Aus der Verwendung einer Gleichspannung zur Beaufschlagung des Kabels ergibt sich aber der wesentliche Nachteil dieses Verfahrens. Die hier fraglichen Kabel dienen üblicherweise der Übertragung von Wechselstrom. Wenn für die vorliegenden Messungen das Kabel mit Gleichspannung beaufschlagt werden soll, so muss dieses Kabel dazu komplett vom Netz getrennt werden, also von seiner Versorgungsquelle getrennt und mit einer besonderen Gleichspannungsquelle verbunden werden. Auch die Verbraucher, z.B. Häuser, müssen bei diesem bekannten Verfahren abgeklemmt werden, da sie von der Gleichspannung beschädigt werden könnten. Dies erfordert einen erheblichen Aufwand und führt zu erheblichen Ausfallzeiten des betroffenen Stromversorgungsnetzes. Soll z. B. das die Häuser an einer Straße versorgende Kabel geprüft werden, so müssen alle Häuser vom Versorgungsnetz getrennt werden.

Wie die gattungsgemäßen Schriften US 3299351 A, die US 4039938 A und die US 3991363 A zeigen, ist eine Schrittspannungsmessung auch mit Wechselspannung möglich, wenn bei dieser eine Polarität markiert wird. Mit Wechselspannung ergeben sich geringere Beeinträchtigungen der an das Kabel angeschlossenen Verbraucher, die zum Anschluss an Wechselspannung ausgelegt sind. Bei Wechselspannung auf dem Kabel ergibt sich eine Wechselspannung an den Elektroden der Auswerteinrichtung und man würde die Richtungsinformation aus dem Vorzeichen der Schrittspannung verlieren, da die Spannungsdifferenz mit der Frequenz der Wechselspannung laufend ihr Vorzeichen ändert. Hier schafft die Markierung einer Polarität der beaufschlagenden Wechselspannung Abhilfe. Die markierte Polarität der Wechselspannung kann bei der Schrittspannungsmessung erkannt werden, und es ist dadurch genauso wie bei der Verwendung einer Gleichspannung eine Richtungsangabe möglich. Nachteilig bei diesen bekannten Messverfahren ist jedoch, dass die Markierung kontinuierlich erfolgt. Es ergibt sich also eine durch die Markierungen kontinuierlich verformte Wechselspannung, die außer für den vorliegenden Messzweck nur schlecht verwendbar ist und bei Verbrauchern starke Störungen verursacht. Daher werden diese Wechselspannungsmethoden grundsätzlich nur an völlig freigeschalteten Kabeln verwendet, was die Nutzbarkeit erneut stark einschränkt.

US 2008157780 A1 beschreibt ein Verfahren zur Ortung eines hochohmigen Masse-Kurzschlussfehlers zwischen einem Schirmleiter und einem Innenleiter eines im Erdreich vergrabenen Koaxialkabels bei dem ein zwischen dem Innenleiter und dem Schirmleiter eingespeistes Ortungssignal eine Störung in dem den Fehlerort umgebenden elektromagnetischen Feld erzeugt. Durch das Aufspüren der Feldstörung bei einer Vermessung des Magnetfeldes entlang der Kabelstrecke kann der Fehlerort bestimmt werden. Das Ortungssignal ist ein Mischsignal bestehend aus einem ersten Trägersignal einer Frequenz von weniger als 2 Hz, vorzugsweise 0,718 Hz und einem zweiten Signal im Bereich von 10.000 Hz. Aus dem Ortungssignal soll ein hörbarer Ton erzeugt werden können, was die Fehlersuche erleichtert.

Aus US 5210497 A ist ein Verfahren zur Ortung eines Erdschlussfehlers in einem Kabel bekannt, bei dem das Kabel mit einem Suchsignal beaufschlagt wird das aus zwei Signalen unterschiedlicher Frequenz erzeugt wird. Der Fehlerort wird ebenfalls mit einer Feldvermessung entlang der Kabelstrecke ermittelt.

Aus US 6798211 B1 ist ein alternatives Verfahren zur Ortung von Erdschlussfehlern in Kabeln bekannt, bei dem die im Fehlerort entstehenden Signalreflexionen gemessen werden und mit einem Modell eines fehlerfreien Kabels verglichen werden. Die daraus abgeleiteten Parameter können herangezogen werden, um die Strecke zwischen dem Vermessungsort und dem Fehlerort zu bestimmen.

Die Aufgabe der vorliegenden Erfindung besteht darin, eine Vorrichtung und ein Verfahren zu schaffen, mit dem eine Nachortung mit Schrittspannungsmessung unter verringerter Störung angeschlossener Verbraucher möglich ist.

Diese Aufgabe wird mit den Merkmalen der Kennzeichnungsteile der Ansprüche 1 und 4 gelöst.

Erfindungsgemäß werden die Vorteile der gattungsgemäß markierten Wechselspannung genutzt. Die erwähnten Nachteile werden aber vermieden, da nur einzelne Halbwellen markiert werden. Die Auswerteinrichtung kann einzelne Markierungen erkennen. Daher benötigt sie keine kontinuierlichen Markierungen. Diese können daher sogar völlig vereinzelt in sehr großen Abständen liegen und führen zu einer nur äußerst geringfügigen Verformung der Wechselspannung, die keine merklichen Störungen verursacht. Diese einzelnen Halbwellen können z.B. auch als Gruppe aus mehreren markierten Halbwellen gleicher Polarität auftreten, denen eine längere Abfolge unmarkierter Halbwellen folgt. Diese Gruppe kann Z.B. zum Zwecke besserer Erkennbarkeit und geringerer Störanfälligkeit ein bestimmtes Muster oder eine bestimmte Kodierung aufweisen. Die einzelnen markierten Halbwellen können aber auch als singuläres Ereignis vereinzelt auftreten, jeweils voneinander durch eine Abfolge unmarkierter Halbwellen getrennt. Die erfindungsgemäße Schrittspannungsmessung kann für Kabel verwendet werden, die von beliebigen leitfähigen Medien umgeben sind. Das Medium ist im Regelfall das Erdreich, kann aber auch Wasser sein, z.B. bei einem Unterwasserkabel. Auch an einem nackten Kabel kann gemessen werde, wenn dieses eine leitfähige Außenoberfläche aufweist.

Da die Erfindung das Kabel mit Wechselspannung beaufschlagt, lässt sich vorteilhaft gemäss Anspruch 2 oder 5 auch die normale Netzspannung verwenden, die im Normalbetrieb vom Kabel übertragen wird. Während der Messung kann also der Normalbetrieb eines Stromversorgungsnetzes aufrecht erhalten werden und es kann ohne jede Störung für die am Netz angeschlossenen Verbraucher gemessen werden. Die geringfügigen Beeinträchtigungen der übertragenen Wechselspannung durch die Formänderung einzelner Halbwellen ist für die Verbraucher nicht störend, da z.B. nur wenige einzelne Halbwellen markiert werden müssen, die mit heute üblichen elektronischen Schaltungen in der Auswerteinrichtung ohne Weiteres auffindbar sind.

Dabei ist vorteilhaft gemäß Anspruch 3 oder 6 die Beaufschlagungsvorrichtung als Netzsicherung ausgebildet. Soll ein fehlerbehaftetes Kabel überprüft werden, so muss nur die zuständige Netzsicherung gefunden, ausgebaut und durch eine erfindungsgemäße Beaufschlagungsvorrichtung ersetzt werden, die hinsichtlich der mechanischen Ausbildung der Anschlüsse entsprechend kompatibel zur Netzsicherung ausgebildet sein muss. Die Beaufschlagungsvorrichtung liegt hierbei in Reihe mit dem Kabel und markiert den durchlaufenden Netzstrom. Sie kann z.B. auch eine elektronische Sicherungsfunktion mit einstellbarer Stromstärke und/oder einstellbarer Abschaltcharakteristik haben. Die Vorrichtung kann vorteilhaft die für ihren Betrieb erforderliche Stromversorgung aus dem Stromnetz beziehen, in das sie zur Beaufschlagung und/oder Sicherung eingebaut wird.

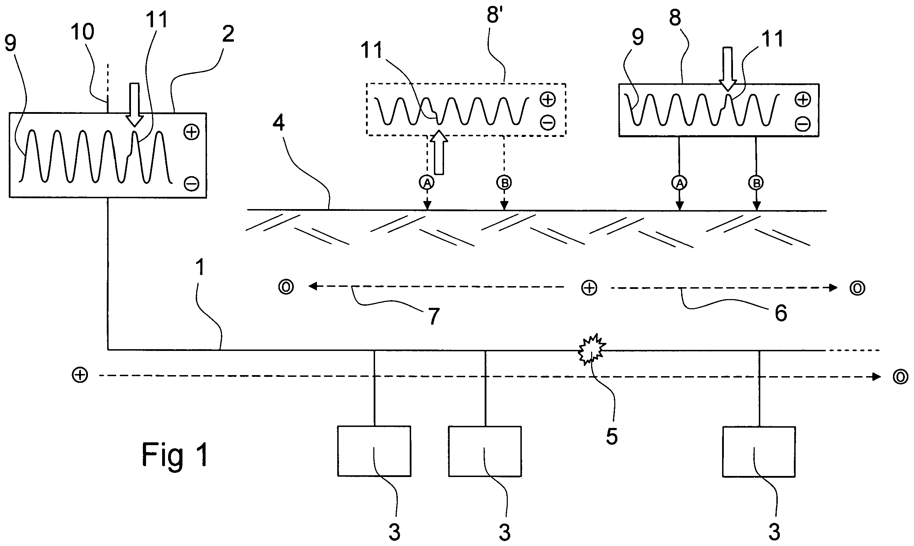

In der Zeichnung ist die Erfindung beispielsweise und schematisch in einer einzigen Fig. 1 erläutert, die in prinzipienhafter Darstellung einen typischen Messaufbau zeigt.

Fig. 1 zeigt ein Kabel 1, das von einer Beaufschlagungseinrichtung 2 her mit Spannung beaufschlagt wird. An das Kabel 1 sind Verbraucher 3 angeschlossen. Das Kabel 1 liegt im gezeigten Beispiel im Erdreich unter der Erdoberfläche 4.

Im Rahmen der Erfindung lassen sich die Vorrichtung und das Verfahren aber auch bei unter Wasser verlegten Kabeln oder auch bei oberirdisch verlegten Kabeln anwenden, z.B. durch Messung von Schrittspannungen direkt an der Kabeloberfläche, wenn z.B. eine leitfähige Verbindung zwischen einem isolationsfehlerbehafteten Leiter eines Kabels zu einer leitenden Abschirmung oder zu der aufgrund von anhaftender Nässe oder anhaftender Verunreinigung leitfähig gewordenen Kabelaußenisolierung. Durch eine intakte Außenisolierung hindurch könnte z.B. auch mit kapazitiv arbeitenden Abgriffsmitteln das anspruchsgemäße Verfahren ausgeführt werden.

Bei dem Kabel 1 kann es sich z. B. um ein Kabel handeln, das entlang einer Straße verlegt ist. Dabei kann es sich bei den Verbrauchern 3 um angeschlossene Häuser handeln. Die Beaufschlagungseinrichtung 2 wäre dann z.B. an die Stelle der für einen Straßenabschnitt zuständigen Sicherung in den entsprechenden Verteilerschrank einzusetzen. Die in Normalbetrieb übertragene Spannung wäre die zur Hausversorgung übliche Wechselspannung von 230 Volt. Bei Anordnung z.B. im Verteiler einer Transformatorstation gelten die nachfolgenden Erläuterungen analog.

Das Kabel 1 hat als Erdkabel einen robusten Mantel, der die im Kabelinneren liegenden Leiter isoliert. Es können ein oder mehrere Leiter in dem Kabel liegen, die jeweils an eine Beaufschlagungseinrichtung 2, z. B. eine entsprechende Sicherung, angeschlossen sind.

Im Kabel befindet sich ein Erdschluss 5, also ein Kabelfehler, bei dem einer der Leiter im Kabel in elektrischem Kontakt nach außen zum kabelumgebenden Erdreich steht. Die Spannung im Kabel liegt bei dem Erdschluss 5 am Erdreich an und erzeugt in diesem einen Stromfluss.

Die Spannungs- und Stromverhältnisse werden nun zunächst für den Gleichstromfall erläutert, also für den Fall der Untersuchung des Kabels nach der Methode des Standes der Technik, die im Kapital 2.2.1 des eingangs genannten Aufsatzes beschrieben ist.

Die Beaufschlagungseinrichtung 2 ist dann eine Gleichspannungsquelle. Aus Sicherheitsgründen müssen die Verbraucher 3 dann vom mit Gleichspannung zu beaufschlagenden Versorgungsnetz getrennt werden. Die Beaufschlagungseinrichtung 2 wird z. B. an der Straßenecke in den Verteilerschrank anstelle einer Sicherung eingebaut und versorgt den den Erdschluss 5 aufweisenden Leiter des Kabels 1 mit einer Gleichspannung einer bestimmten Polarität, z. B. (+). Mit gestrichelten Pfeilen ist in Fig. 1 der sich dann im Erdreich ergebende Stromfluss eingezeichnet.

Im Kabel 1 fließt demnach der Strom, unter Beachtung der Definition der so genannten technischen Stromrichtung, von (+) nach (0). Am Erdschluss 5 wird die Spannung (+) an das Erdreich gelegt, und es fließt ein Strom von dort nach allen Seiten im Erdreich vom Erdschluss weg gegen (0). Dies ist in Richtung des Kabels 1 in der Fig. 1 mit Pfeilen 6 und 7 dargestellt, die parallel bzw. antiparallel zur Stromrichtung im Kabel 1 verlaufen. Es fließen auch Ströme in Richtung zur Erdoberfläche 4.

Eine Auswerteinrichtung 8 ist oberhalb der Erdoberfläche 4 angeordnet und zwar in Kabelstromrichtung hinter dem Erdschluss 5, also oberhalb des Pfeiles 6. Die Auswerteinrichtung 8 steht mit zwei mit (A) und (B) gekennzeichneten Elektroden in Kontakt mit der Erdoberfläche 4. Die Elektroden können als übliche Erdspieße ausgebildet sein, die elektrisch gut kontaktierend in die Erdoberfläche eingestochen werden.

Unter den Elektroden (A) und (B) fließt in Richtung des Pfeiles 6 Strom durch die Erde. Mit den Elektroden (A) und (B) wird somit ein Spannungsabfall auf der Erdoberfläche 4 abgegriffen, der üblicherweise als Schrittspannung bezeichnet wird.

Die beiden Elektroden der Auswerteinrichtung 8 sind in der Fig. 1 zur Unterscheidung mit (A) und (B) gekennzeichnet, um ihre räumliche Orientierung zum Erdschluss 5 diskutieren zu können, also z. B. die Frage, welche der beiden Elektroden (A) und (B) näher zum Erdschluss 5 liegt.

Im bisher diskutierten Fall der in Fig. 1 mit gestrichelten Pfeilen dargestellten Gleichströme, die von (+) nach (0) laufen, ergibt sich aus Fig. 1, dass die Elektrode (A) näher zum Erdschluss 5 liegt. Als Schrittspannung, also Differenzspannung zwischen den Elektroden (A) und (B) (U(A)-U(B)), ergibt sich ein Wert mit einer bestimmten Polarität, mit einem bestimmten Vorzeichen, der im vorliegenden Fall positiv ist. Daraus kann man ablesen, dass die Elektrode (A) näher am Erdschluss 5 liegt, denn aus dem Vorzeichen der Schrittspannung ist bei der vorgegebenen Polarität der beaufschlagten Gleichspannung zu folgern, dass bei Elektrode (A) das Potential höher ist als bei Elektrode (B).

In Fig. 1 ist gestrichelt ein anderer Aufstellungsort 8' der Auswerteinrichtung dargestellt. Die Orientierung der Elektroden (A) und (B) in Kabelstromrichtung ist dieselbe wie im vorher beschriebenen Fall. Man sieht jedoch, dass der abgegriffene Strom gemäß Pfeil 7 in die entgegengesetzte Richtung fließt als gemäß Pfeil 6. Es ergibt sich folglich eine Differenzspannung zwischen (A) und (B) (U(A)-U(B)) mit umgekehrter Polarität. Daraus kann man erkennen, dass der Erdschluss 5 in Richtung der Elektrode (B) liegt.

Durch diese einfache Messung kann man mit der Auswerteinrichtung 8 also erkennen, in welcher Richtung der bisher noch unbekannte Ort des Erdschlusses 5 liegt. Man kann sich also gezielt annähern.

Außerdem kann man natürlich die Höhe der Differenzspannung auswerten und daraus zusätzliche Rückschlüsse auf die Lage ziehen.

Erfindungsgemäß wird mit der Beaufschlagungseinrichtung 2 jedoch keine Gleichspannung, sondern eine Wechselspannung 9 auf das Kabel 1 gegeben. Diese beaufschlagte Wechselspannung ist in Fig. 1 innerhalb des rechteckigen Kastens angegeben, der schematisch die Beaufschlagungseinrichtung 2 darstellt.

Die beaufschlagende Wechselspannung 9 hat positive und negative Halbwellen, was innerhalb des Kastens 2 mit (+) und (-) bezeichnet ist. Man sieht in Fig. 1, dass eine der positiven Halbwellen der Beaufschlagungsspannung 9 verformt ist. Die erste Hälfte dieser positiven Halbwelle 11 ist mit entsprechenden elektronischen Mitteln, z. B. einer Thyristorschaltung, unterdrückt. Bei der Beaufschlagungsspannung 9 handelt es sich um die normale Wechselspannung des Netzes, das vom ankommenden Netz 10 her an die Beaufschlagungseinrichtung 2 angelegt ist.

Die auf diese Weise markierte positive Halbwelle 11 ist in der Fig. 1 zur besseren Erkennbarkeit mit einem Pfeil markiert. Es werden bevorzugt von der Beaufschlagungseinrichtung 2 weitere Halbwellen durch Verformung markiert (nicht dargestellt), die natürlich alle ebenfalls die gleiche Polarität haben. Diese können in größeren Abständen voneinander liegen, z. B. kann jede hundertste Halbwelle markiert sein. Die Beaufschlagungseinrichtung kann z.B. in festen zeitlichen Abständen eine Markierung vornehmen, z.B. alle 2 oder 3 Sekunden. Dies erleichtert die Unterscheidung einer markierten Halbwelle von irgendwelchen Störungen.

Auf dem Kabel 1 liegt daher die normale Netzwechselspannung, nur leicht moduliert durch einige, formveränderte Halbwellen einer Polarität. Die Verbraucher 3 können also störungsfrei weiterbetrieben werden.

Würde man eine normale, nicht markierte Wechselspannung verwenden, so würde die Schrittspannungsmessung mit der Auswerteinrichtung 8 immer abwechselnde Polaritäten mit der Frequenz der Netzspannung ergeben. Eine Zuordnung des Vorzeichens der gemessenen Spannung zu einer bestimmten Polarität der beaufschlagten Spannung wäre nicht möglich, so wie dies bei der bekannten Verwendung von Gleichspannung der Fall ist.

Erfindungsgemäß ist die Wechselspannung jedoch bei einer bestimmten Polarität mit der verformten Halbwelle 11 markiert. Dadurch ist bei der Wechselspannung eine Polarität gegenüber der anderen markiert und kann wiedererkannt werden.

Die Auswerteinrichtung 8 ist dazu ausgebildet, die markierte Halbwelle 11 in der markierten Wechselspannung 9 aufzufinden. Sie kann also die Verknüpfung leisten, bei welcher Polarität der beaufschlagten Spannung das Schrittspannungssignal welches Vorzeichen hat, und es kann nun mit denselben einfachen Algorithmen wie im oben diskutierten Gleichspannungsfall die Aussage getroffen werden, ob der Erdschluss 5 in Richtung der Elektrode (A) oder der Elektrode (B) liegt. Die Auswerteinrichtung muss dazu nur die Polarität der markierten Halbwelle wissen, z.B. weil festgelegt ist, dass immer eine positive Halbwelle markiert wird, oder die Beaufschlagungseinrichtung 2 kommuniziert zur Auswerteinrichtung 8, ob positive oder negative Halbwellen markiert werden.

Zum Vergleich ist auch bei der nach links verschobenen Auswerteinrichtung 8' das dort ermittelte Wechselspannungssignal 9 dargestellt. Man sieht, dass die gemessene Schrittspannung vorzeichenumgekehrt und der markierte Impuls 11' nun negativ ist.

Die bei 2, 8 und 8' angegebenen Markierungspfeile zur Hervorhebung der markierten Halbwellen 11 bzw. 11' markieren alle dasselbe Ereignis, die aber ggf. mit Zeitversatz auftreten.

Mit derselben Messung, die bei Stellung der Auswerteinrichtung 8 oberhalb des Pfeiles 6 die Aussage ergibt, dass die Elektrode (A) in Richtung zum Erdschluss 5 liegt, wird an der Stelle 8' die Aussage erhalten, dass die Elektrode (B) in Richtung zum Erdschluss 5 liegt.

Die Beaufschlagungseinrichtung 2 kann vom Gehäuse und den Anschlüssen her wie eine übliche Sicherung ausgebildet sein, die zur Absicherung des Kabels 1 verwendet wird. Insbesondere kann sie in ihren Abmessungen so dimensioniert sein, dass ein üblicher und genormter Verteilerschrank auch nach dem Einbau der Beaufschlagungseinrichtung 2 noch verschlossen werden kann.

Soll ein Erdschluss 5 gesucht werden, so wird zunächst die normale Sicherung herausgenommen und die Beaufschlagungseinrichtung 2 eingesetzt. Diese könnte ohne Sicherungsfunktion ausgebildet sein und nur die Markierung der markierten Halbwellen 11 liefern. Sie kann aber auch mit allen Funktionen einer Sicherung ausgebildet sein und diese vollständig ersetzen. Zusätzliche Funktionen sind möglich, wie z. B. Speichermittel zur laufenden Aufzeichnung des Strom- und Spannungsverlaufs, z.B. zur laufenden Überwachung des Kabels 1 auf sporadisch auftretende Fehler oder dergleichen.

Anstelle positiver markierter Halbwellen 11 können natürlich auch negative markierte Halbwellen verwendet werden. Die Auswerteinrichtung 8 muss jedoch darüber informiert sein, um diesen Vorzeichenwechsel beachten zu können. Die Auswerteinrichtung 8 ist bevorzugt als mobiles, das heißt von einem Benutzer tragbares Gerät ausgebildet.

Gemäß dem in Figur 1 dargestellten Ausführungsbeispiel wird die Schrittspannungsmessung mittels zweier Erdspieße ausgeführt. In alternativen erfindungsgemäßen Ausführungsformen kann die Messung aber z.B. auch kapazitiv erfolgen.

## Patentansprüche

1. Vorrichtung zur Ortung eines Erdschlusses (5) an einem von einem leitfähigen Medium umgebenen Stromversorgungskabel (1) durch Schrittspannungsmessung an einer zugänglichen Oberfläche (4) des Mediums, mit einer Einrichtung (2) zur Beaufschlagung des Kabels (1) mit einer Spannung (9) bestimmter Polarität und mit einer Einrichtung (8) zur Auswertung der Schrittspannung, die ermittelt, welcher von zwei Abgriffen (A, B) der Auswerteinrichtung näher zum Erdschluss (5) liegt, **dadurch gekennzeichnet, dass** die beaufschlagende Spannung eine für an das Stromversorgungskabel angeschlossene Verbraucher vorgesehene Wechselspannung (9) ist, bei der die bestimmte Polarität markiert ist, indem wenigstens eine einzelne Halbwelle (11) oder eine Gruppe von Halbwellen der bestimmten Polarität durch Formänderung markiert ist, der eine Folge unmarkierter Halbwellen der gleichen Polarität folgt, wobei die Auswerteinrichtung (8) dazu ausgebildet ist, ein Schrittspannungssignal als zeitlichen Verlauf (9) der Schrittspannung zu ermitteln und darin einzelne markierte Halbwellen (11) zu erkennen sowie deren Polarität zu ermitteln.

2. Vorrichtung nach Anspruch 1, **dadurch gekennzeichnet, dass** die Beaufschlagungsvorrichtung (2) dazu ausgebildet ist, die markierte Wechselspannung (9) durch Modulation der Netzspannung (10) eines in Betrieb stehenden Stromversorgungsnetzes zu erzeugen.

3. Vorrichtung nach Anspruch 2, **dadurch gekennzeichnet, dass** die Beaufschlagungsvorrichtung (2) als Netzsicherung ausgebildet ist.

4. Verfahren zur Ortung eines Erdschlusses (5) an einem von einem leitfähigen Medium umgebenen Stromversorgungskabel (1) durch Schrittspannungsmessung an einer zugänglichen Oberfläche (4) des Mediums, unter Beaufschlagung des Kabels (1) mit einer Spannung (9) bestimmter Polarität und Auswertung der Schrittspannung, wobei ermittelt wird, welcher von zwei Abgriffen (A, B) der Auswerteinrichtung näher zum Erdschluss (5) liegt, **dadurch gekennzeichnet, dass** die beaufschlagende Spannung als eine für an das Stromversorgungskabel angeschlossene Verbraucher vorgesehene Wechselspannung (9) erzeugt wird, bei der die bestimmte Polarität markiert wird, indem wenigstens eine einzelne Halbwelle (11) der bestimmten Polarität oder eine Gruppe von Halbwellen der bestimmten Polarität durch Formänderung markiert wird, der eine Folge unmarkierter Halbwellen der gleichen Polarität folgt, wobei die Auswerteinrichtung (8) ein Schrittspannungssignal als zeitlichen Verlauf (9) der Schrittspannung ermittelt und darin einzelne markierte Halbwellen (11) erkennt sowie deren Polarität ermittelt.

5. Verfahren nach Anspruch 4, **dadurch gekennzeichnet, dass** die markierte Wechselspannung (9) durch Modulation der Netzspannung (10) eines in Betrieb stehenden Stromversorgungsnetze erzeugt wird.

6. Verfahren nach Anspruch 5, **dadurch gekennzeichnet, dass** zu Beginn des Verfahrens die das Kabel (1) sichernde Netzsicherung durch die zu dieser kompatible Beaufschlagungsvorrichtung (2) ersetzt wird.

## Claims

1. Device for locating a short-circuit to earth (5) on a power supply cable (1) surrounded by a conductive medium by means of step voltage measurement on an accessible surface (4) of the medium, with a device (2) for applying a voltage (9) of a particular polarity to the cable (1), and with a device (8) for the evaluation of the step voltage that determines which of two pick-ups (A, B) of the evaluation device is closer to the short-circuit to earth (5),
**characterised in that**
- the voltage being applied is an alternating voltage (9) provided for the consumers connected to the power supply cable, for which the particular polarity is marked by at least one single half-wave (11) or a group of half-waves of the particular polarity being marked by a change of shape that is followed by a series of unmarked half-waves, with the evaluation device (8) being designed to determine a step voltage signal as a time sequence (9) and to detect individual half-waves marked therein (11) as well as to determine their polarity.

2. Device according to Claim 1,
**characterised in that**
- the device applying voltage (2) is configured to generate the marked alternating voltage (9) by the modulation of the mains voltage (10) of a power supply network in operation.

3. Device according to Claim 2,
**characterised in that**
- the device applying voltage (2) is designed as a mains fuse.

4. Method for locating a short-circuit to earth (5) on a power supply cable (1) surrounded by a conductive medium by means of step voltage measurement on an accessible surface (4) of the medium, with a voltage (9) of a particular polarity being applied to the cable (1) and with evaluation of the step voltage, it being determined which of two pick-ups (A, B) of the evaluation device is closer to the short-circuit to earth (5),
**characterised in that**
- the voltage being applied is generated as an alternating voltage (9) provided for consumers connected to the power supply cable, in the case of which the particular polarity is marked by at least one single half-wave
(11) of the particular polarity or a group of half-waves of the particular polarity being marked by change of shape that is followed by a series of unmarked half-waves of the same polarity, with the evaluation device (8) determining a step voltage signal as a time sequence (9) of the step voltage and therein detecting individual marked half-waves (11) and determining their polarity.

5. Method according to Claim 4,
**characterised in that**
- the marked alternating voltage (9) is generated by modulation of the mains voltage (10) of a power supply network in operation.

6. Method according to Claim 5,
**characterised in that**
- at the beginning of the method, the mains fuse protecting the cable (1) is replaced by the voltage-applying device (2) that is compatible with the mains fuse.

## Revendications

1. Dispositif de localisation d'un défaut à la terre (5) dans un câble (1) d'alimentation en courant électrique entouré d'un milieu conducteur par mesure d'une tension de pas sur une surface accessible (4) du milieu à l'aide d'une installation (2) qui applique au câble (1) une tension (9) d'une polarité définie, et d'une installation d'évaluation (8) de la tension de pas permettant de déterminer lequel de deux points de mesure (A, B) de l'installation d'évaluation est le plus proche du défaut à la terre (5), **caractérisé en ce que** la tension appliquée est une tension alternative (9) prévue pour un consommateur branché sur le câble d'alimentation en courant électrique, la polarité définie de cette tension étant marquée par une modification de forme d'au moins une demi-onde individuelle (11) ou d'un groupe de demi-ondes de cette polarité définie suivie(s) d'une séquence de demi-ondes de même polarité non marquées, l'installation d'évaluation (8) étant conçue de façon à pouvoir déterminer un signal de tension de pas comme variation dans le temps (9) de la tension de pas et détecter des demi-ondes marquées (11) individuelles qui y sont contenues et en déterminer la polarité.

2. Dispositif selon la revendication 1, **caractérisé en ce que** le dispositif (2) d'application de la tension est conçu de façon à pouvoir produire la tension alternative marquée (9) par modulation de la tension de réseau (10) d'un réseau de distribution de courant en service.

3. Dispositif selon la revendication 2, **caractérisé en ce que** le dispositif (2) d'application de la tension est conçu sous forme d'un coupe-circuit de secteur.

4. Procédé de localisation d'un défaut à la terre (5) dans un câble (1) d'alimentation en courant électrique entouré d'un milieu conducteur par mesure d'une tension de pas sur une surface accessible (4) du milieu en appliquant au câble (1) une tension (9) d'une polarité définie et en évaluant la tension de pas et en déterminant lequel de deux points de mesure (A, B) de l'installation d'évaluation est le plus proche du défaut à la terre (5), **caractérisé en ce que** la tension appliquée est produite comme tension alternative (9) prévue pour un consommateur branché sur le câble d'alimentation en courant électrique, la polarité définie de cette tension étant marquée par une modification de forme d'au moins une demi-onde individuelle (11) de cette polarité définie ou d'un groupe de demi-ondes de cette polarité définie suivie(s) d'une séquence de demi-ondes de même polarité non marquées, l'installation d'évaluation (8) déterminant un signal de tension de pas comme variation dans le temps (9) de la tension de pas et y détectant des demi-ondes marquées (11) individuelles qui y sont contenues et dont elle détermine la polarité.

5. Procédé selon la revendication 4, **caractérisé en ce que** la tension alternative marquée (9) est produite par modulation de la tension de réseau (10) d'un réseau de distribution de courant en service.

6. Procédé selon la revendication 5, **caractérisé en ce que,** en début de procédé, le coupe-circuit de secteur qui protège le câble (1) est remplacé par le dispositif (2) d'application de la tension compatible avec ce coupe-circuit.
